# EUROPEAN PATENT APPLICATION

(11) **EP 1 983 073 A1**
(43) Date of publication of application: **22.10.2008**
(21) Application number: 08154630.1
(22) Date of filing: 16.04.2008
(51) Int. Cl.: C23C 16/18, C23C 16/16

(54) **Metal precursor solutions for chemical vapor deposition**

(30) Priority: 16.04.2007 US 911970 P; 28.03.2008 US 58200
(71) Applicant: Air Products and Chemicals, Inc., Allentown, PA 18195-1501 (US)
(72) Inventor: Lei, Xinjian, Vista, CA 92081 (US); Quinn, Liam J., Carlsbad, CA 92008 (US); Norman, John Anthony Thomas, Encinitas, CA 92024 (US); Burgoyne, William Franklin, Jr., Bethlehem, PA 18015 (US); Lal, Gauri Sankar, Whitehall, PA 18052 (US); Ulman, Michael, Mertztown, PA 19539 (US); Spence, Daniel P., San Diego, CA 92117 (US)
(74) Representative: Muir, Benjamin M. J.

(57) **Abstract**

Metal source containing precursor liquid solutions for chemical vapor deposition processes, including atomic layer deposition, for fabricating conformal metal-containing films on substrates are described. More specifically, the metal source precursor liquid solutions are comprised of (i) at least one metal complex selected from β-diketonates, β-ketoiminates, β-diiminates, alkyl metal, metal carbonyl, alkyl metal carbonyl, aryl metal, aryl metal carbonyl, cyclopentadienyl metal, cyclopentadienyl metal isonitrile, cyclopentadienyl metal nitrile, cyclopentadienyl metal carbonyl, metal alkoxide, metal ether alkoxide, and metal amides wherein the ligand can be monodentate, bidentate and multidentate coordinating to the metal atom and the metal is selected from group 2 to 14 elements, and (ii) a solvent selected from organic amides including linear amides and cyclic amides for such metal source containing precursors.

## Description

### BACKGROUND OF THE INVENTION

The semiconductor fabrication industry continues to use metal source containing precursors for chemical vapor deposition processes including atomic layer deposition for fabricating conformal metal-containing films on substrates such as silicon, silicon oxide, metal nitride, metal oxide and other metal-containing layers using these metal source containing precursors. In the fabrication process, a particularly advantageous way of delivering multiple source containing precursors is to employ neat liquid source containing liquid metal precursors or solutions of metal source precursors dissolved in a solvent, flash to vaporize the mixture, and then deliver the resulting vapors to the reactor. If in the fabrication process the reactions convert the metal source containing precursor to an insoluble or non-volatile product, or to a material of different chemical or physical properties, the elements contained in that product may not reach the substrate and the stoichiometry of the deposited film may not be correct.

In certain instances, such problems can be avoided sometimes by using identical ligands coordinated to the metals to make ligand exchange a degenerate reaction (i.e., where the exchanging ligand is identical to the original ligand). The foregoing problems also may be encountered where the precursor is provided in a liquid solution and the solvent contains moieties which react with the metal or ligands of the precursor to produce undesirable reaction by-products.

The following references are illustrative of metal source containing precursor solutions for use in preparing conformal metal-containing films: US 5,820,664; US 6,225,237; US 6,984,591; US2006/0269667; Lee, D.-J., S.-W. Kang and S.-W. Rhee (2001). "Chemical vapor deposition of ruthenium oxide thin films from Ru(tmhd)3 using direct liquid injection." Thin Solid Films 413: 237; US 6,111,122; Moshnyaga, V., I. Khoroshun, A. Sidorenko, P. Petrenko, A. Weidinger, M. Zeitler, B. Rauschenbach, R. Tidecks and K. Samwer (1999). "Preparation of rare-earth manganite-oxide thin films by metalorganic aerosol deposition technique." Applied Physics Letters 74(19): 2842-2844; US 5,900,279; US 5,916,359; and JP 06234779.

### BRIEF SUMMARY OF THE INVENTION

The present invention generally relates to an improvement in metal source containing precursor solutions suitable for use in chemical vapor deposition processes, including cyclic chemical vapor deposition as well as atomic layer deposition, for fabricating conformal metal-containing films on substrates and to such processes. More specifically, the metal source precursor solutions are comprised of (i) at least one metal coordination complex including a metal, to which is coordinatively bound at least one ligand in a stable complex and (ii) a solvent, comprised of an organic amide, for such metal source containing precursors. Preferably the ligand(s) for metal complex are selected from: β-diketonates, β-ketoiminates, β-ketoesters, alkyl, carbonyl, alkylcyclopentadineyl, and alkoxy.

Some of the advantages which may be available through the use of these solutions include the following:
an ability to provide metal source precursor compositions in liquid solution form to simultaneously deliver the constituent metal(s) to a deposition locus such as a chemical vapor deposition or atomic layer deposition chamber;
an ability to provide solutions which are resistant to deleterious ligand exchange reactions;
an ability to provide a solution containing a high boiling linear or cyclic organic amide;
an ability to stabilize a metal complex in both liquid and gas phase via coordinating the organic amide to the metal center,
an ability to promote the vaporization of the metal complex via a direct liquid injection device; and,
an ability to tune the physical properties of the precursor solution such as viscosity for easy delivery.

### BRIEF DESCRIPTION OF THE DRAWINGS

Figure 1 is a Thermo Gravimetric Analysis (TGA) of 1.0 M solution of titanium isopropoxide in N-methyl-2-pyrrolidinone.
Figure 2 is a TGA of 0.1 M solution of tris(2,2,6,6-tetramethyl-3,5-heptanedionate)lanthanum in N-methyl-2-pyrrolidinone.
Figure 3 shows TGAs of solutions of tetrakis(ethylmethylamino)zirconium (TEMAZ) in N-methyl-2-pyrrolidinone: A (10% NMP in TEMAZ); B (40% NMP in TEMAZ); C (50% NMP in TEAM).
Figure 4 is a TGA of 0.3M of tetrakis(dimethylamine)hafnium in N-methyl-2-pyrrolidinone.
Figure 5 shows TGAs of solutions of Cu-Kl3 (CF₃C(O)CHC(NCH₂CH₂OSiMe₂C₂H₃)CF₃)Cu) in N-methyl-2-pyrrolidinone: 1 (8% NMP in KI3); 2 (12% NMP in Kl-3); 3 (27% NMP in KI3).

### DETAILED DESCRIPTION OF THE INVENTION

In reference to the above, the broadly based metal source precursor solutions are comprised of at least one metal coordination complex including a metal, to which is coordinatively bound at least one ligand in a stable complex. Representative metal complexes include metal β-diketonates,metal β-ketoiminates,metal β-diiminates, metal β-ketoesters alkyl metal, metal carbonyl, alkyl metal carbonyl, aryl metal, aryl metal carbonyl, cyclopentadienyl metal, alkylcycopentadienyl metal, cyclopentadienyl metal isonitrile, cyclopentadienyl metal nitrile, carbonyl cyclopentadienyl metal, metal alkoxide, metal ether alkoxide, and metal amides. The ligand can be monodentate, bidentate and multidentate coordinating to the metal atom and the metal is selected from group 2 to 14 elements. Generally the valence of the metal is from 2 to 5.

Embodiments of the above metal source containing precursors are represented by the following generalized formulas:
(a) Metal β-diketonates having the formula: 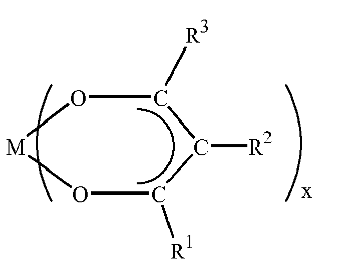 wherein M is a metal selected from Group 2 to 14, e.g. those having a valence from 2 to 5 and specific examples of metals include Mg, Ca, Sr, Ba, Y, La, Ce, Sm, Tb, Er, Yb, Lu, Ti, Zr, Hf, Fe, Co, Ni, Ru, Ir, Rh, Cu, Al, Sn, and Pb; wherein R¹⁻³ are linear, branched, or cyclic independently selected from hydrogen, C₁₋₁₀ alkyl, C₁₋₁₀ alkenyl, C₃₋₁₀ alkylsilyl, C₁₋₁₀ alkynyl, C₅-C₁₀ cycloaliphatic, C₆₋₁₂ aryl, and fluorinated C₁₋₁₀ alkyl; wherein x is the integer 2, 3, or 4 based upon the valence of the metal.
   Illustrative β-diketonate ligands employed in metal source complexes of the present invention include: acetylacetonate or more specifically 2,4-pentanedionate (acac), hexafluoroacetylacetonate or more specifically 1,1,1,5,5,5-hexafluoro-2,4-pentanedionate (hfacac); trifluoroacetylacetonate or more specifically 1,1,1-trifluoro-2,4-pentanedionate (tfacac); tetramethylheptanedionate or more specifically 2,2,6,6-tetramethyl-3,5-heptanedionate (thd); fluorodimethyloctanedionate or more specifically 1,1,1,2,2,3,3-heptafluoro-7,7-dimethyl-4,6-octanedionate (fod); and heptafluoro - dimethyloctanedionate. Exemplary metal complexes include Sr(thd)₂,, Ba(thd)₂, Co(acac)₂, Ni(acac)₂, Cu(acac)₂, Ru(thd)₃, La(thd)₃, Y(thd)₃, Ti(thd)₄, Hf(thd)₄, and Zr(thd)₄.
(b) Metal β-ketoiminates having the formula: 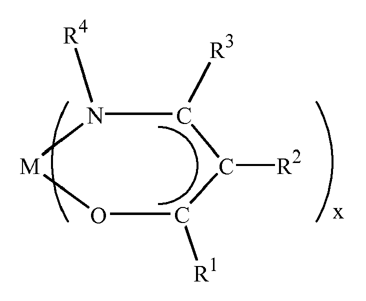 wherein M is a metal selected from Group 2 to 14, and specific examples of metals include Mg, Ca, Sr, Ba, Y, La, Ce, Sm, Tb, Er, Yb, Lu, Ti, Zr, Hf, Fe, Co, Ni, Ru, Ir, Rh, Cu, Al, Sn, and Pb; wherein R¹⁻³ are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl; wherein x is the integer 2, 3, or 4 consistent with the valence of M; R⁴ is linear, branched or cyclic selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl.
(c) Metal β-diiminates having the formula: 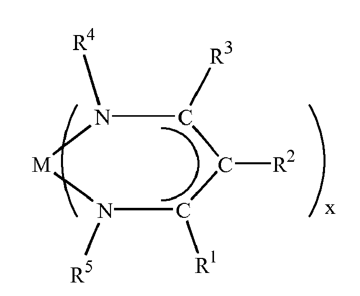 wherein M is selected from Group 2 to 13, and specific examples of metals include Mg, Ca, Sr, Ba, Y, La, Ce, Sm, Tb, Er, Yb, Lu, Ti, Zr, Hf, Fe, Co, Ni, Ru, Ir, Rh, Cu, Al, Sn, and Pb; wherein R¹⁻³ are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl; wherein x is the integer 2, 3, or 4. R⁴⁻⁵ also can contain unsaturation bonds and are linear, branched or cyclic independently selected from the groups consisting of hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl.
(d) Metal Alkoxy β-diketonates having the formula: 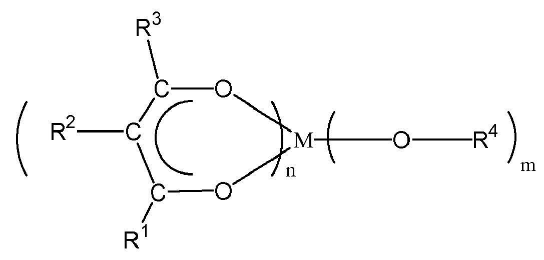 wherein M is a metal ion selected from Group 4 and 5 metals including titanium, zirconium, hafnium, vanadium, niobium, and tantalum; wherein R¹⁻³ are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl ; R⁴ is linear, branched or cyclic independently selected from C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl; wherein m and n are at least 1 and the sum of m plus n is equal to the valence of the metal M. Exemplary metal complexes include Ti(thd)₂(OBu^{t})₂, Hf(thd)₂(OBu^{t})₂, and Zr(thd)₂(OBu^{t})₂.
(e) Alkyl Metal β-diketonates having the formula: 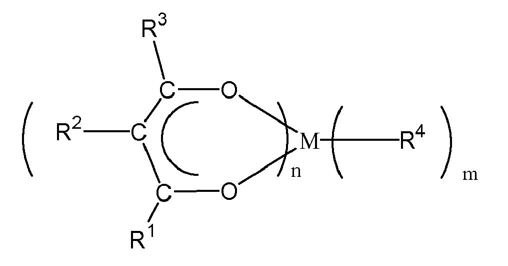 wherein M is a metal ion selected from Group 8, 9, and 10 metals including iron, cobalt, nickel, ruthenium, rhodium, palladium, osmium, iridium, platium; wherein R¹⁻³ are linear, branched or cyclic independently selected from hydrogen, C₁₋₁₀ alkyl, C₁₋₁₀ alkenyl, C₁₋₁₀ alkynyl, C₃-₁₀ alkylsilyl, C₅-C₁₀ cycloaliphatic, C₆₋₁₂ aryl, and fluorinated C₁₋₁₀ alkyl; wherein R⁴ is linear, branched or cyclic independently selected from C₁₋₁₀ alkyl, C₁₋₁₀ alkenyl, C₁₋₁₀ alkynyl, C₅-C₁₀ cycloaliphatic, C₆₋₁₀ cycloalkene, C₆₋₁₂ cycloalkyne, C₆₋₁₂ aryl, C₃₋₁₀ alkylsilyl, and fluorinated C₁₋₁₀ alkyl; wherein m and n are at least 1, and the sum of m plus n is equal to the valence of the metal M or n is equal to the valence of the metal M if R⁴ is a neutral ligand. Exemplary metal complexes include but are not limited to bis(2,2,6,6-tetramethyl-3,5-heptanedionato)(1,5-cyclo-octadiene)ruthenium(II).
(f) Metal Alkoxy β-ketoiminates with the formula: 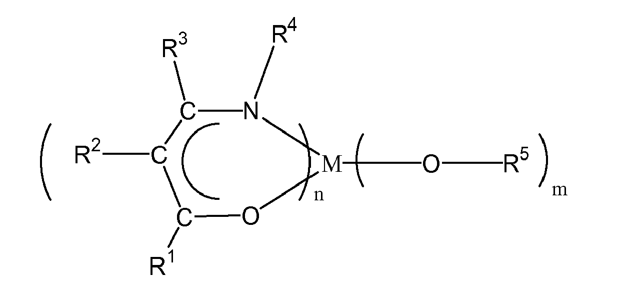 wherein M is a metal ion selected from Group 4 and 5 metals including titanium, zirconium, hafnium, vanadium, niobium, and tantalum; wherein R¹⁻⁵ are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl; wherein m and n are at least 1 and the sum of m plus n is equal to the valence of the metal M.
(g) Metal β-ketoiminates with the formula: 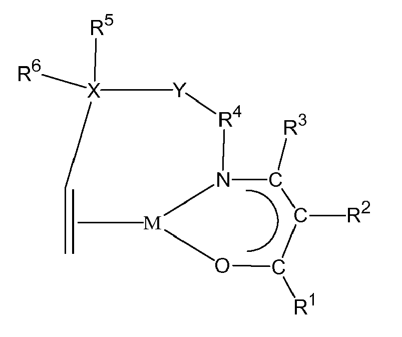 wherein M is a metal ion selected from Group 11 metals including copper, silver, and gold; wherein R^{1*-2*} are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl or halogen; R³⁻⁴ are linear or branched independently selected from C₁₋₆ alkyl, C₁₋₆ alkenyl, C₁₋₆ alkynyl and fluorinated C₁₋₆ alkyl, preferably R⁴ is a 2 to 4 carbon atom linkage, more preferably R⁴ is a 2 to 3 carbon atom linkage, thus making a five- or six-member coordinating ring to the metal center; R⁵⁻⁶ are linear, branched or cyclic independently selected from C₁₋₁₀ alkyl, C₁₋₁₀ alkenyl, C₁₋₁₀ alkynyl, C₅-C₁₀ cycloaliphatic, C₆₋₁₂ aryl, fluorinated C₁₋₁₀ alkyl or connected to form a ring containing carbon, oxygen, and/or nitrogen atoms; X is either a carbon or a silicon, and Y is either an oxygen, or a nitrogen substituted with a hydrogen, C₁₋₆ alkyl or C₆₋₁₀ aryl group. Exemplary metal complexes include Cu(CF₃C(O)CHC(NCH₂CH₂OSiMe₂C₂H₃)CF₃), Cu(CF₃C(O)CHC(NCH₂CH₂OSiMe₂C₂H₃)Me), Cu(MeC(O)CHC(NCH₂CH(Me)OSiMe₂C₂H₃)Me), Cu(MeC(O)CHC(NCH₂CH₂OSiMe₂C₂H₃)Me), Cu(MeC(O)CHC(NCH₂CH₂N(Me)SiMe₂C₂H₃)Me), Cu(MeC(O)CHC(NCH(Et)CH₂OSiMe₂C₂H₃)Me).
(h) Metal alkyl having the formula:

   MR¹ₓR²_{y}

   wherein M is a metal selected from Group 2 to 14 where specific examples of metals include Mg, Ca, Sr, Ba, Y, La, Ce, Sm, Tb, Er, Yb, Lu, Ti, Zr, Hf, Fe, Co, Ni, Ru, Ir, Rh, Cu, Al, Sn, and Pb; wherein R¹ and R² are linear, branched or cyclic independently selected from the groups consisting of hydrogen, C₁₋₁₀ alkyl, C₁₋₁₀ alkenyl, C₁₋₁₀ alkynyl, C₅-C₁₀ cycloaliphatic, C₃₋₁₀ alkylsilyl, C₆₋₁₂ aryl, and fluorinated C₁₋₁₀ alkyl, cyclopendienyl (Cp) and alkylcyclopendienyl; and wherein x is the integer 0,1, 2, 3, or 4; y is the integer 0,1, 2, 3, or 4 and x + y = the valence of M; and Me represents -CH₃. Exemplary metal complexes include CoCp₂, SrCp₂, Sr(ⁱPrCp)₂, Sr(ⁱPr₃Cp)₂, BaCp₂, Ba(ⁱPrCp)₂, Ba(ⁱPr₃Cp)₂, RuCp₂, Ru(EtCp)₂, Ru(MeCp)(EtCp), Ru( DMPD)(EtCp), NiCp₂, Cp₂HfMe₂, and Cp₂ZrMe₂.
(i) Alkyl metal carbonyl having the formula:

   (CO)_{y}MRₓ

   wherein M is a metal selected from Group 2 to 14 where specific examples of metals include Mg, Ca, Sr, Ba, Y, La, Ce, Sm, Tb, Er, Yb, Lu, Ti, Zr, Hf, Re, Fe, Co, Ni, Ru, Ir, Rh, Cu, Al, Sn, and Pb; wherein R is linear, branched or cyclic independently selected from hydrogen, C₁₋₁₀ alkyl, C₁₋₁₀ alkenyl, C₁₋₁₀ alkynyl, C₅-C₁₀ cycloaliphatic, C₃₋₁₀ alkylsilyl, C₆₋₁₂ aryl, and fluorinated C₁₋₁₀ alkyl, cyclopendienyl (Cp) and alkylcyclopendienyl and mixtures thereof; wherein x = 2, 3, 4; y = 1, or, 2, or 3, or 4 and x = the valence of M. Exemplary metal complexes include Cp₂Ru(CO)₂, (1,3-cycohexdiene)Ru(CO)₃, CpRe(CO)₃, CpCo(CO)₂ and ⁱPrCpRe(CO)₃.
(j) Metal carbonyl with the formula:

   Mₓ(CO)_{y}

   wherein M is a metal selected from Group 6 to 10, more preferably 8 to 10 where specific examples of metals include Fe, Co, Ni, Ru, W, Mo, Ir, and Rh; wherein x is an integer 1, 2, or 3; y is an integer 4 to 12. Preferably, x times the valence of the metal = 2y. Exemplary metal complexes include Ru₃(CO)₁₂, W(CO)₆, Mo(CO)₆, Co₂(CO)₈, and Ni(CO)₄.
(k) Metal alkoxide with the formula:

   M(OR)n

   wherein M is a metal selected from Group 2 to 14 where specific examples of metals include Mg, Ca, Sr, Ba, Y, La, Ce, Sm, Tb, Er, Yb, Lu, Ti, Zr, Hf, Ta, Fe, Co, Ni, Ru, Ir, Rh, Cu, Al, Sn and Pb; wherein R is linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl, and fluorinated C₁₋₁₀ alkyl and mixtures thereof; wherein n is an integer 2, 3, 4 or 5, comprising the valence of M. Exemplary metal complexes include Ti(ⁱPrO)₄, Hf(OBu^{t})₄, Zr(OBu^{t})₄, and Ta₂(OEt)₁₀.
(l) Metal amides with the formula:

   M(NR¹R²)ₙ
wherein M is selected from Group 2 to 14 where specific examples of metals include Mg, Ca, Sr, Ba, Y, La, Ce, Sm, Tb, Er, Yb, Lu, Ti, Zr, Hf, Ta, W, Fe, Co, Ni, Ru, Ir, Rh, Cu, Al, Sn, and Pb; wherein R¹⁻² are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, C₃₋₁₀ alkylsilyl, and fluorinated C₁₋₁₀ alkyl; wherein n is the integer 2, 3, 4, or 5, comprising the valence of M.

Exemplary metal complexes include tetrakis(dimethylamino)titanium (TDMAT), tetrakis(diethylamino)titanium (TDEAT), tetrakis(ethylmethylamino)titanium (TEMAT), tetrakis(dimethylamino)zirconium (TDMAZ), tetrakis(diethylamino)zirconium (TDEAZ), tetrakis(ethylmethylamino)zirconium (TEMAZ), tetrakis(dimethylamino)hafnium (TDMAH), tetrakis(diethylamino)hafnium (TDEAH), tetrakis(ethylmethylamino)hafnium (TEMAH), tert-butylimino tri(diethylamino)tantalum (TBTDET), tert-butylimino tri(dimethylamino)tantalum (TBTDMT), tert-butylimino tri(ethylmethylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethylamino)tantalum (TAIMAT), tert-amylimino tri(diethylamino)tantalum, pentakis(dimethylamino)tantalum, tert-amylimino tri(ethylmethylamino)tantalum, bis(tert-butylimino)bis(dimethylamino)tungsten (BTBMW), bis(tert-butylimino)bis(diethylamino)tungsten, bis(tert-butylimino)bis(ethylmethylamino)tungsten.

Summarizing, the ligand groups of the metal source containing precursor complexes in the broad practice of the present invention may be variously substituted to produce a wide variety of materials to optimize volatility, stability and film purity. Preferably, when the metal source precursor comprises two or more metal source containing precursor complexes, the ligands of the various metal source containing precursor complexes should be either: (a) identical, to result in degenerative ligand exchange (wherein any ligand exchange involves replacement of the ligand group by the same type ligand from another constituent of the multicomponent solution); or, (b) resistant to any detrimental non-degenerative ligand exchange in relation to one another, which would substantially impair or preclude the efficacy of the metal source complex for its intended purpose.

The metal source containing precursors generally are selected for solution applications on the basis of the following criteria: (i) the metal centers in the coordinated complexes should be as coordinatively saturated as possible, and in such respect multidentate ligands are preferred which occupy multiple coordination sites in the source precursor complex; (ii) the ligands preferably comprise sterically bulky groups such as isopropyl, t-butyl, and neopentyl, which prevent intermolecular interaction of the metal centers and thus hinder ligand exchange reaction and (iii) each of the individual metal source precursors in the solution should have a suitable vapor pressure characteristic, e.g., a vapor pressure of at least 0.001 Torr (0.13 Pa) at the temperature and pressure conditions involved in their volatilization.

The solvent medium employed in formulating the metal source precursor solutions in accordance with the present invention is the organic amide class of the form, RCONR'R", wherein: R and R' are linear or branched alkyl having from 1-10 carbon atoms or R and R' can be connected such that RCONR' forms a cyclic group; and R" is alkyl having from 1 to 4 carbon atoms or cycloalkyl. Where R and R' are connected they preferably form the bridging group (CH₂)ₙ, wherein n is from 2-4, preferably 3, thus resulting in a 4-6, preferably 5, membered cyclic group. N-methyl, N-ethyl, and N-cyclohexyl 2- pyrrolidinones are examples of the preferred solvents of the organic amide class.

The metal source precursor solutions of the present invention may be readily employed in chemical vapor deposition (CVD) applications including atomic layer deposition (ALD) for forming a metal-containing film on a substrate by the steps of volatilizing the metal source precursor liquid solution to yield a metal source vapor, and contacting the metal source vapor with the substrate, to deposit the metal-containing film thereon.

The following examples illustrate the preparation of the metal-containing complexes as precursor solutions in metal-containing film deposition processes and their use in a chemical vapor deposition process.

### Example 1

### Preparation of 1.0M solution of titanium isopropoxide in N-methyl-2-pyrrolidinone

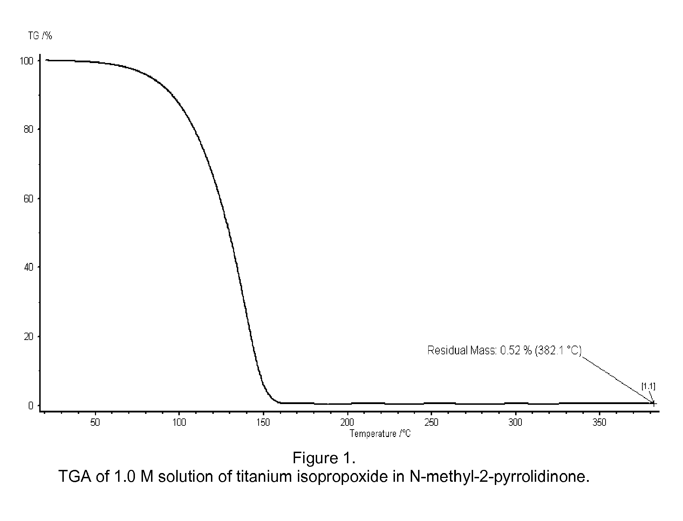

In a 2mL vial, a faint yellow orange solution of titanium isopropoxide (0.10g, 0.35mmol) and 0.35mL N-methyl-2-pyrrolidinone (NMP) was prepared. The solution was kept at room temperature over night and did not show any visible change. Figure 1 is a TGA of the 1.M solution of titanium isopropoxide in N-methyl-2-pyrrolidinone, suggesting a smooth vaporization process in the temperature range of 20 to 400°C. This vaporization behavior suggests the solution can be employed either via bubbling or direct liquid injection for chemical vapor deposition or atomic vapor deposition.

### Example 2

### Preparation of 0.1 M solution of tris(2,2,6,6-tetramethyl-3,5-heptanedionate)lanthanum in N-methyl-2-pyrrolidinone

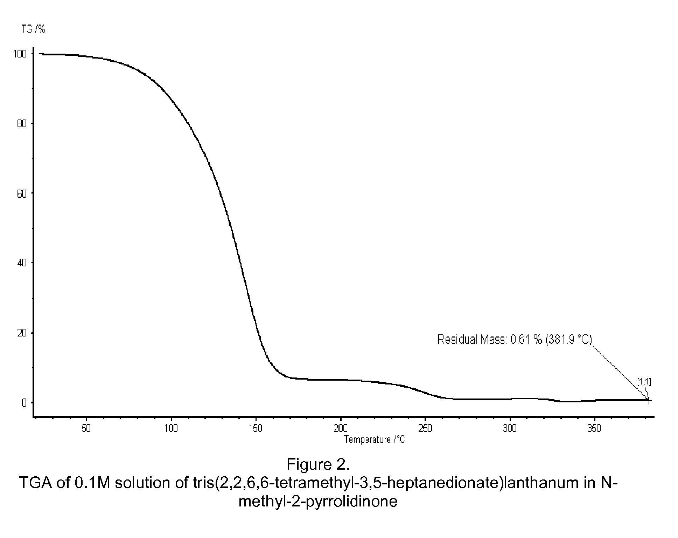

In a 2mL vial, a clear solution of La(thd)₃) (0.05g, 0.07mmol) and 0.78mL NMP was prepared. Figure 2 is a TGA of 0.1M solution of tris(2,2,6,6-tetramethyl-3,5-heptanedionate)lanthanum in N-methyl-2-pyrrolidinone, indicating there are two vaporization processes, the first is mainly for NMP and the second tris(2,2,6,6-tetramethyl-3,5-heptanedionate)lanthanum. This vaporization behavior suggests the solution can be only employed via direct liquid injection for chemical vapor deposition or atomic vapor deposition.

### Example 3

### Preparation of solutions of tetrakis(ethylmethylamino)zirconium in N-methyl-2-pyrrolidinone

Three solutions of tetrakis(ethylmethylamino)zirconium (TEMAZ) in NMP were prepared according to Table 1. All are clear yellow solutions.

**Table 1**

| Sample | TEMAZ (g) | NMP (g) |
|---|---|---|
| A | 0.2 | 1.8 |
| B | 0.24 | 0.35 |
| C | 0.2 | 0.2 |

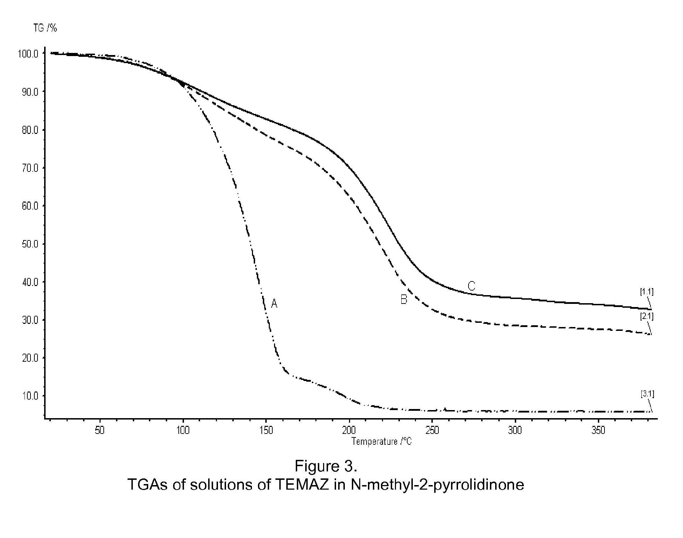

Figure 3 shows TGA diagrams of the solutions, suggesting that direct liquid injection with a lower concentration is preferred.

### Example 4

### Preparation of 0.3M of tetrakis(dimethylamino)hafnium in N-methyl-2-pyrrolidinone

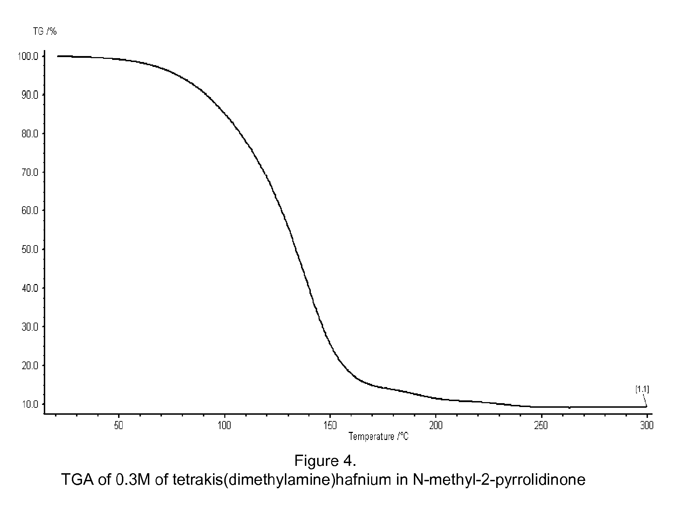

The procedure of Example 1 is followed in preparing the above solution. Figure 4 is a TGA graph of a 0.3M yellow solution of tetrakis(dimethylamino)hafnium (TDMAH) in N-methyl-2-pyrrolidinone, suggesting that direct liquid injection with lower concentration is preferred.

### Example 5

### Preparation of 1.0M solution of tetrakis(diethylamino)zirconium in N-cyclohexyl-2-pyrrolidinone

In a 2mL vial, a clear orange solution of tetrakis(diethylamino)zirconium (TDEAZ) (0.05g, 0.07mmol) and 0.27 g of N-cyclohexyl-2-pyrrolidinone was prepared. The TGA graph indicates the solution is volatile and can be used as precursor source in a CVD or ALD process.

### Example 6

### Preparation of 0.01 M solution of tungsten carbonyl in N-methyl-2-pyrrolidinone

In a 2mL vial, a clear yellow solution of tungsten carbonyl (0.10g, 0.17mmol) and 12 g of N-methyl-2-pyrrolidinone was prepared. The TGA graph indicates the solution is volatile and can be used as precursor source for CVD or ALD.

### Example 7

### Preparation of 0.01 M solution of bis(2,2,6,6-tetramethyl-3,5-heptanedionato)(1,5-cyclooctadiene)ruthenium(II) in N-methyl-2-pyrrolidinone

In a 2mL vial, a clear orange solution of bis(2,2,6,6-tetramethyl-3,5-heptanedionato)(1,5-cyclo-octadiene)ruthenium(II) (0.10g, 0.28mmol) and 20 g of N-methyl-2-pyrrolidinone was prepared. The TGA graph indicates the solution is volatile and can be used as precursor source for CVD or ALD.

### Example 8

### Preparation of solutions of (CF₃C(O)CHC(NCH₂CH₂OSiMe₂C₂H₃)CF₃)Cu in N-methyl-2-pyrrolidinone

Table 2 below shows the weights of the copper metal complex Cu-Kl3 (i.e., (CF₃C(O)CHC(NCH₂CH₂OSiMe₂C₂H₃)CF₃)Cu) mixed with dry deoxygenated NMP solvent under nitrogen. After thoroughly mixing, three solutions 1, 2 and 3 were individually tested in a TGA/DSC (Differential Scanning Calorimetry) apparatus.

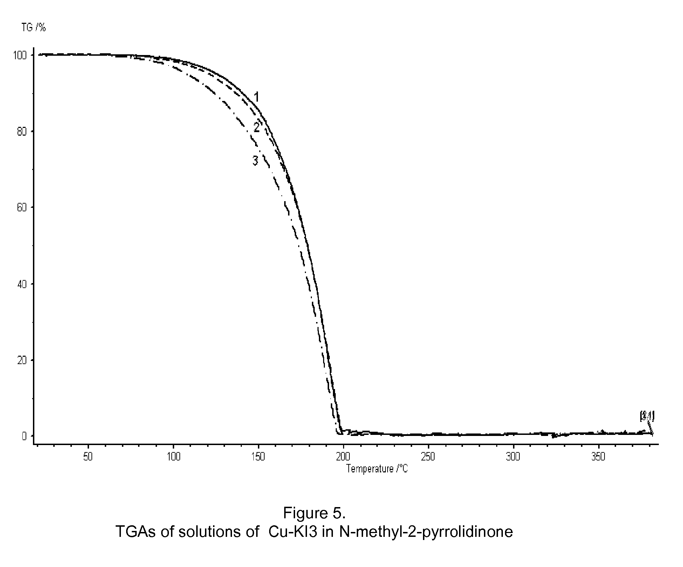

In this system, a small sample of 1,2 or 3 was placed in a microbalance and a steady flow of nitrogen passed over the sample as it was steadily heated. Evaporation is registered as weight loss, manifest as a smooth curve down to almost complete evaporation. Since all three samples do not show two stages of evaporation per sample, i.e., the solvent evaporates first and then the copper complex evaporates, it is evident that these mixtures represent excellent blends for Direct Liquid Injection (DLI) type delivery for a CVD or ALD process. The TGA graphs are shown in Figure 5.

**Table 2. NMP added to Cu-K13**

| Sample | Weight of Cu-KI3 | Weight of NMP | Wt %age NMP added |
|---|---|---|---|
| 1 | 0.787g | 0.063g | 8.0 |
| 2 | 0.284g | 0.035g | 12.0 |
| 3 | 0.145g | 0.039g | 27.0 |

### Example 9

### Preparation of 1 M solution of bis(ethylcyclopentadienyl)ruthenium in N-methyl-2-pyrrolidinone

In a 2mL vial, an amber solution of bis(ethylcyclopentadienyl)ruthenium (1.00g, 2.88mmol) and 2.97g of N-methyl-2-pyrrolidinone was prepared. The TGA graph indicates the solution is completely vaporized, leaving no residue.

### Example 10

### Preparation of 0.25M solution of bis(n-propyltetramethylcyclopentadienyl)barium in N-methyl-2-pyrrolidinone

In a 2mL vial, a clear yellow solution of bis(n-propyltetramethyl cyclopentadienyl) barium (0.14g, 0.30mmol) and 1.24g of N-methyl-2-pyrrolidinone was prepared. The TGA graph shows the solution is more volatile than pure bis(n-propyltetramethylcyclopentadienyl)barium, suggesting NMP enhances the vaporization of bis(n-propyltetramethylcyclopentadienyl)barium.

### Example 11

### Preparation of 0.5M solution of tris(i-propylcyclopentadienyl)lanthanum in N-methyl-2-pyrrolidinone

In a 2mL vial, a clear solution of tris(i-propylcyclopentadienyl)lanthanum (0.21 g, 0.46mmol) and 0.94g of N-methyl-2-pyrrolidinone was prepared. The TGA graph indicates the solution is volatile and can be used as precursor source for CVD or ALD.

### Example 12

### Preparation of 0.38M solution of bis(2,2,6,6-tetramethyl-3,5-heptanedionate)strontium in N-methyl-2-pyrrolidinone

In a 2mL vial, a yellow solution of bis(2,2,6,6-tetramethyl-3,5-heptanedionate)strontium (0.23g, 0.51 mmol) and 1.38g of N-methyl-2-pyrrolidinone was prepared. The TGA graph shows the solution is more volatile than pure bis(2,2,6,6-tetramethyl-3,5-heptanedionate)strontium, suggesting NMP enhances the vaporization of bis(2,2,6,6-tetramethyl-3,5-heptanedionate)strontium.

### Example 13

### Preparation of 0.25M solution of bis(2,2,6,6-tetramethyl-3,5-heptanedionate)barium in N-methyl-2-pyrrolidinone

In a 2mL vial, a foggy white solution of bis(2,2,6,6-tetramethyl-3,5-heptanedionate)barium (0.14g, 0.28mmol) and 1.14g of N-methyl-2-pyrrolidinone was prepared. The TGA graph indicates the solution is volatile and can be used as precursor source for CVD or ALD.

### Example 14

### CVD copper using a solution of precursor Cu-KI3 (i.e., Cu(CF₃C(O)CHC(NCH₂CH₂OSiMe₂C₂H₃)CF₃ )) dissolved in NMP delivered by DLI mode with formic acid vapor as reagent gas.

Process details: A Gartek single wafer CVD reactor fitted with a Direct Liquid Injector (DLI) system was used to individually process ruthenium and titanium coated silicon wafers at a process chamber pressure of 1 Torr (130 Pa) and wafer temperature of 150°C. The copper precursor was utilized as a 3:1 by weight ratio of CuKl3 dissolved in dry N-methylpyrolidone (NMP) and injected into the vaporizer at a rate of 41 mg/min using an evaporation temperature of 100°C with an argon carrier gas flow of 250 sccm. Formic acid vapor was delivered by the DLI of 82 mg of liquid formic acid/min using an evaporation temperature of 65°C with an argon carrier gas flow rate of 100 sccm. Run time was 30 minutes.

Results: Ruthenium: 427.5 nm of copper (as confirmed by EDX (energy dispersive x-ray) analysis) were deposited to give, after correcting for the ruthenium underlayer conductivity, a resitivity of 2.6 µΩcm.

Results: Titanium nitride: 386.7 nm of copper (as confirmed by EDX analysis) were deposited to give, after correcting for the titanium nitride underlayer, a resistivity of 2.3 µΩcm.

## Claims

1. A metal source precursor solution having utility for chemical vapor deposition or atomic layer deposition in the manufacture of semiconductor device structures, said metal source precursor solution consisting essentially of:
(i) at least one metal coordination complex comprising a metal coordinatively bound to at least one ligand in a stable complex; and,
(ii) an organic amide solvent for said metal coordination complex.

2. The metal source precursor solution of Claim 1 wherein the metal coordination complex is selected from:
(a) Metal β-diketonates having the formula: 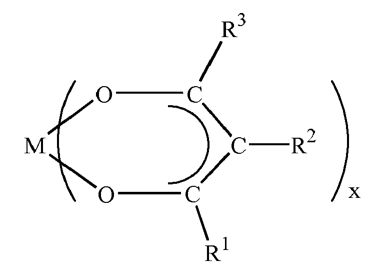 wherein M is a metal selected from Group 2 to 14; R¹⁻³ are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl; and x is an integer 2, 3, or 4 depending on the valence of M;
(b) Metal β-ketoiminates having the formula: 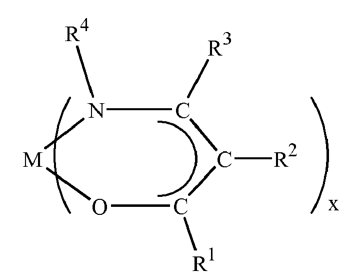 wherein M is a metal selected from Group 2 to 14; R¹⁻³ are linear, branched or cyclic independently selected from hydrogen, C₁₋₁₀ alkyl, C₁₋₁₀ alkenyl, C₁₋₁₀ alkynyl, C₃₋₁₀ alkylsilyl, C₅-C₁₀ cycloaliphatic, C₆₋₁₂ aryl, and fluorinated C₁₋₁₀ alkyl; R⁴ is linear, branched, or cyclic selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl, and fluorinated C₁₋₁₀ alkyl; and x is an integer 2, 3, or 4 depending on the valence of M;
(c) Metal β-diiminates having the formula: 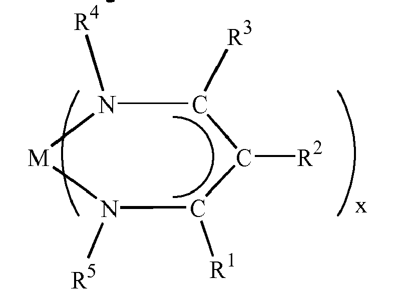 wherein M is a metal selected from Group 2 to 13; R¹⁻³ are linear, branched or cyclic independently selected from hydrogen, C₁₋₁₀ alkyl, linear C₁₋₁₀ alkenyl, C₁₋₁₀ alkynyl, C₅-C₁₀ cycloaliphatic, C₆₋₁₂ aryl, C₃₋₁₀ alkylsilyl, and fluorinated C₁₋₁₀ alkyl; R⁴⁻⁵ are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl; and x is an integer 2, 3, or 4 depending on the valence of M;
(d) Metal Alkoxy β-diketonates having the formula: 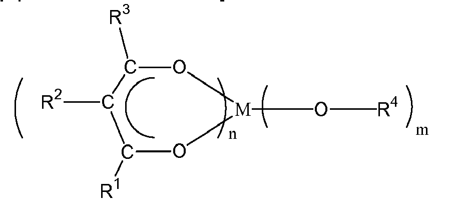 wherein M is a metal selected from Group 4 and 5 metals; R¹⁻³ are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl ; R⁴ is linear, branched or cyclic independently selected from C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl; and m and n are both at least 1 and the sum of m plus n is equal to the valence of the metal M;
(e) Alkyl Metal β-diketonates having the formula: 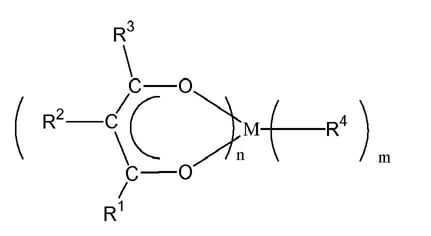 wherein M is a metal selected from Group 8, 9, and 10 metals; R¹⁻³ are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl; wherein R⁴ is linear, branched or cyclic independently selected from C₁₋₁₀ alkyl, C₁₋₁₀ alkenyl, C₁₋₁₀ alkynyl, C₅-C₁₀ cycloaliphatic, C₆₋₁₀ cycloalkene, C₆₋₁₂ cycloalkyne, C₆₋₁₂ aryl, C₃₋₁₀ alkylsilyl and fluorinated C₁₋₁₀ alkyl; and m and n are both each at least 1, and either the sum of m plus n is equal to the valence of the metal M or n is equal to the valence of the metal M if R⁴ is a neutral ligand;
(f) Metal Alkoxy β-ketoiminates having the formula: 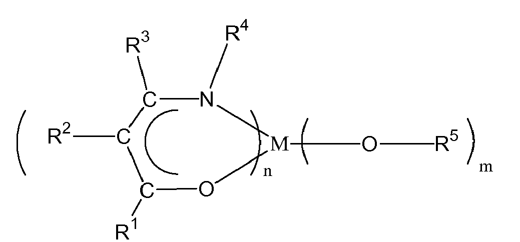 wherein M is a metal selected from Group 4 and 5 metals; R¹⁻⁵ are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl; and m and n are at least 1 and the sum of m plus n is equal to the valence of the metal M;
(g) Metal β-ketoiminates with the formula: 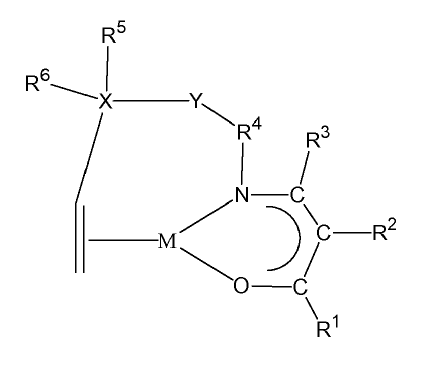 wherein M is a metal selected from Group 11 metals; R^{1*-2*} are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl, fluorinated C₁₋₁₀ alkyl and halogen; R³⁻⁴ are linear or branched independently selected from C₁₋₄ alkyl, C₁₋₄ alkenyl, C₁₋₄ alkynyl and fluorinated C₁₋₄ alkyl; R⁵⁻⁶ are linear, branched or cyclic independently selected from C₁₋₁₀ alkyl, C₁₋₁₀ alkenyl, C₁₋₁₀ alkynyl, C₅-C₁₀ cycloaliphatic, C₆₋₁₂ aryl, and fluorinated C₁₋₁₀ alkyl or are connected to form a ring containing carbon, oxygen, and/or nitrogen atoms; X is either a carbon or a silicon; and Y is either an oxygen, or a nitrogen substituted with a hydrogen, C₁₋₆ alkyl or C₆₋₁₀ aryl group;
(h) Metal alkyl having the formula:
MR¹ₓR²_{y}
wherein M is a metal selected from Group 2 to 14; R¹ and R² are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl, fluorinated C₁₋₁₀ alkyl, cyclopendienyl and alkylcyclopendienyl; x is an integer 0,1, 2, 3, or 4; y is an integer 0,1, 2, 3, or 4; and x + y = the valence of M;
(i) Alkyl metal carbonyl having the formula:
(CO)_{y}MRₓ
wherein M is a metal selected from Group 2 to 14; R is linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl, fluorinated C₁₋₁₀ alkyl, cyclopendienyl and alkylcyclopendienyl; x is the integer 2, 3, or 4; y is the integer 1, 2, 3, or 4; and x = the valence of M;
(j) Metal carbonyl with the formula:
Mₓ(CO)_{y}
wherein M is a metal selected from Group 6 to 10; x is the integer 1, 2, or 3 and y is an integer from 4 to 12;
(k) Metal alkoxide with the formula:
M(OR)n
wherein M is a metal selected from Group 2 to 14; R is linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl; and n is the integer 2, 3, 4, or 5 equal to the valence of M; and
(l) Metal amides with the formula:
M(NR¹R²)ₙ
wherein M is a metal selected from Group 2 to 14; R¹⁻² are linear, branched or cyclic independently selected from hydrogen, C₁₋₁₀ alkyl, C₁₋₁₀ alkenyl, C₁₋₁₀ alkynyl, C₅-C₁₀ cycloaliphatic, C₆₋₁₂ aryl, C₃₋₁₀ alkylsilyl and fluorinated C₁₋₁₀ alkyl; and n is the integer 2, 3, 4, or 5 equal to the valence of M;

3. The metal source precursor solution of Claim 2 wherein the metal coordination complex is selected from formulas (a), (b), and (c), and the metal is selected from Mg, Ca, Sr, Ba, Y, La, Ce, Sm, Tb, Er, Yb, Lu, Ti, Zr, Hf, Fe, Co, Ni, Ru, Ir, Rh, Cu, Al, Sn, and Pb.

4. The metal source precursor solution of Claim 3 wherein the ligand is selected from of acetylacetonate, hexafluoroacetylacetonate; trifluoroacetylacetonate; tetramethylheptanedionate; fluorodimethyloctanedionate; and heptafluoro-dimethyloctanedionate.

5. The metal source precursor solution of Claim 4 wherein the metal coordination complex is selected from Sr(tetramethylheptanedionate)₂, Ba(tetramethylheptanedionate)₂, Co(acetylacetonate)₂, Ni(acetylacetonate)₂, Cu(acetylacetonate)₂, Ru(tetramethylheptanedionate)₃, La(tetramethylheptanedionate)₃, Y(tetramethylheptanedionate)₃, Ti(tetramethylheptanedionate)₄, Hf(tetramethylheptanedionate)₄, and Zr(tetramethylheptanedionate)₄.

6. The metal source precursor solution of Claim 2 wherein the metal coordination complex is selected from the formulas (d) and the metal is selected from titanium, zirconium, hafnium, vanadium, niobium, and tantalum.

7. The metal source precursor solution of Claim 2 wherein the metal coordination complex is represented by the formula (k) and is selected from Ti(ⁱPrO)₄, Hf(OBu^{t})₄, Zr(OBU^{t})₄, and Ta₂(OEt)₁₀.

8. The metal source precursor solution of Claim 2 wherein metal coordination complex is represented by the formula (i) and is selected from (cyclopendienyl)₂Ru(CO)₂, (1,3-cycohexdiene)Ru(CO)₃, (cyclopendienyl)Co(CO)₂, (cyclopendienyl)Re(CO)₃, and ⁱPr(cyclopendienyl)Re(CO)₃.

9. The metal source precursor solution of Claim 2 where metal coordination complex is represented by the formula (j) and is selected from Ru₃(CO)₁₂, W(CO)₆, Mo(CO)₆, Co₂(CO)₈, and Ni(CO)₄.

10. The metal source precursor solution of Claim 2 wherein the metal coordination complex is bis(2,2,6,6-tetramethyl-3,5-heptanedionato)(1,5-cyclooctadiene)ruthenium(II).

11. The metal source precursor solution of Claim 2 wherein the metal coordination complex is represented by the formula (h) and is selected from Co(cyclopendienyl)₂, Sr(cyclopendienyl)₂, Sr(ⁱPr(cyclopendienyl))₂, Sr(ⁱPr₃(cyclopendienyl))₂, Ba(cyclopendienyl)₂, Ba(ⁱPr(cyclopendienyl))₂, Ba(ⁱPr₃(cyclopendienyl))₂, Ru(cyclopendienyl)₂, Ru(Me(cyclopendienyl))(Et(cyclopendienyl)), Ru(Et(cyclopendienyl))₂, Ni(cyclopendienyl)₂, (cyclopendienyl)₂HfMe₂, and (cyclopendienyl)₂ZrMe₂.

12. The metal source precursor solution of Claim 2 wherein the metal coordination complex is represented by the formula (I) and is selected from tetrakis(dimethylamino)titanium, tetrakis(diethylamino)titanium, tetrakis(ethylmethylamino)titanium, tetrakis(dimethylamino)zirconium, tetrakis(diethylamino)zirconium, tetrakis(ethylmethylamino)zirconium, tetrakis(dimethylamino)hafnium, tetrakis(diethylamino)hafnium, tetrakis(ethylmethylamino)hafnium, tert-butylimino tri(diethylamino)tantalum, tert-butylimino tri(dimethylamino)tantalum, tert-butylimino tri(ethylmethylamino)tantalum, ethylimino tri(diethylamino)tantalum, ethylimino tri(dimethylamino)tantalum, ethylimino tri(ethylmethylamino)tantalum, tert-amylimino tri(dimethylamino)tantalum, tert-amylimino tri(diethylamino)tantalum, pentakis(dimethylamino)tantalum, tert-amylimino tri(ethylmethylamino)tantalum, bis(tert-butylimino)bis(dimethylamino)tungsten, bis(tert-butylimino)bis(diethylamino)tungsten, and bis(tert-butylimino)bis(ethylmethylamino)tungsten.

13. The metal source precursor solution of Claim 2 wherein the metal coordination complex is selected from Cu(CF₃C(O)CHC(NCH₂CH₂OSiMe₂C₂H₃)CF₃), Cu(CF₃C(O)CHC(NCH₂CH₂OSiMe₂C₂H₃)Me), Cu(MeC(O)CHC(NCH₂CH(Me)OSiMe₂C₂H₃)Me), Cu(MeC(O)CHC(NCH₂CH₂OSiMe₂C₂H₃)Me), Cu(MeC(O)CHC(NCH₂CH₂N(Me)SiMe₂C₂H₃)Me), Cu(MeC(O)CHC(NCH(Et)CH₂OSiMe₂C₂H₃)Me).

14. The metal source precursor solution of any preceding claim wherein the solution comprises two or more metal coordination complexes and the ligands of the metal coordination complexes are either (a) identical to result in degenerative ligand exchange, or (b) resistant to non-degenerative ligand exchange in relation to one another.

15. The metal source precursor solution of any preceding claim wherein the solvent comprises an amide represented by the formula:
RCONR'R"
wherein R and R' are linear or branched alkyl having from 1-10 carbon atoms or are connected such that RCONR' is a cyclic group where R + R' = (CH₂)ₙ and n is from 2-4; and wherein R" is alkyl having from 1 to 4 carbon atoms or cycloalkyl.

16. The metal source precursor solution of Claim 15 wherein the solvent is selected from N-methyl-2- pyrrolidinone, N-ethyl 2- pyrrolidinone and N-cyclohexyl 2-pyrrolidinone.

17. A process for the vapor deposition employing a metal-containing precursor solution for forming a conformal metal-containing film wherein said metal-containing precursor solution is vaporized in a chamber and the metal deposited onto a substrate, which comprises using the metal source precursor solution of any preceding claim as said metal-containing precursor solution.
